# EUROPEAN PATENT APPLICATION

(11) **EP 2 549 153 A1**
(43) Date of publication of application: **23.01.2013**
(21) Application number: 11755807.2
(22) Date of filing: 02.02.2011
(51) Int. Cl.: F16J 15/10, H04M 1/02, H05K 5/06

(54) **WATERPROOF STRUCTURE, WATERPROOFING METHOD, AND ELECTRONIC DEVICES USING SAID STRUCTURE AND METHOD**

(30) Priority: 15.03.2010 JP 2010058034
(71) Applicant: NEC Corporation, Tokyo 108-8001 (JP)
(72) Inventor: KITAGAWA, Takeharu, Tokyo 108-8001 (JP); YOSHIHIRO, Takaaki, Tokyo 108-8001 (JP); MINOWA, Tomoji, Tokyo 108-8001 (JP); ITOU, Takeshi, Tokyo 108-8001 (JP); TSUJI, Ryosuke, Tokyo 108-8001 (JP)
(74) Representative: Vossius & Partner
(86) International application number: PCT/JP2011/000558
(87) International publication number: WO 2011/114614

(57) **Abstract**

Provided is a waterproof structure including: a first casing component member 107; a second casing component member 110 that is fitted to the first casing component member 107 and constitutes a casing; an annular groove portion 71 formed in the first casing component member 107; and an annular seal member 110c that is provided on the second casing component member 110 and inserted into the groove portion 71. A cross section of the seal member 110c includes: a base portion BH; a trunk portion RH formed substantially perpendicular from the base portion BH; and a valve portion VH formed to protrude in a triangular shape from one side surface on a tip side of the trunk portion, and in a fitted state, the trunk portion and the valve portion are housed in an enclosed space formed by the base portion and the groove portion.

## Description

### Technical Field

The present invention relates to a waterproof structure, a waterproofing method, and an electronic device using the structure and method.

### Background Art

In portable devices, an increase in thickness due to the addition of new functions and a reduction in thickness to avoid the increase in thickness using new technologies have been repeated. Waterproof function is one of trends of the recent portable devices. Portable devices including such a waterproof function are in widespread use. A typical waterproof structure is a seal including a seal member made of rubber. Examples of such a waterproof structure include a type in which a seal member is sandwiched between two members forming a casing, and a type in which a seal member is integrally molded on one of two members forming a casing and is sandwiched between the one member and the other member. The directions in which the seal member is sandwiched include a direction (Z direction) perpendicular to the principal surface of the casing, a principal surface direction (XY direction) of the casing casing, and a combination thereof.

Figs 13A to 13E are external views of a commercially-available folding type portable telephone having a waterproof function. Fig. 13A is an external view showing the front surface in an unfolded state (opened state). As shown in Fig. 13A, in this portable telephone, a first casing 1 and a second casing 2 are foldably connected by a hinge portion 3. The first casing 1 is provided with a main display portion 4. The second casing 2 is provided with various operation keys 5.

Fig. 13B is an external view showing the front surface in a folded state (closed state). As shown in Fig. 13B, a sub-display portion 6 is provided on the surface opposite to the surface on which the main display portion 4 of the first casing 1 is provided.
Fig. 13C is an external view showing a side surface in the closed state. As shown in Fig. 13C, the second casing 2 includes a front cover 7 and a rear cover 8.

Fig. 13D is an external view showing the back surface in the closed state. As shown in Fig. 13D, a camera 9 and a detachably mounted battery cover 10 are provided on the surface opposite to the surface on which the operation keys 5 of the second casing 2 are provided.
Fig. 13E is an external view showing the battery cover 10 in a dismounted state. As shown in Fig. 13E, the battery cover 10 is provided with a guide claw 10a.

Figs. 14A and 14B are sectional views taken along the line XIV-XIV of Fig. 13D. Fig. 14A shows a state (fitted state) in which the battery cover 10 is mounted, and Fig. 14B shows a state (non-fitted state) in which the battery cover 10 is dismounted. As shown in Figs. 14A and 14B, the battery cover 10 includes an intermediate plate 10b of a resin mold, a seal member 10c made of silicon rubber, and an outer cover 10d of a resin mold.

The seal member 10c is an O-ring having a circular cross section and is integrally formed with the intermediate plate 10b. Compression molding, transfer molding, injection (LIM) molding, or the like is used as integral molding. In this case, before the integral molding, a primer that generates an adhesive force is applied between the seal member 10c and the intermediate plate 10b. Further, the intermediate plate 10b is joined with the outer cover 10d with a double-sided tape or the like.

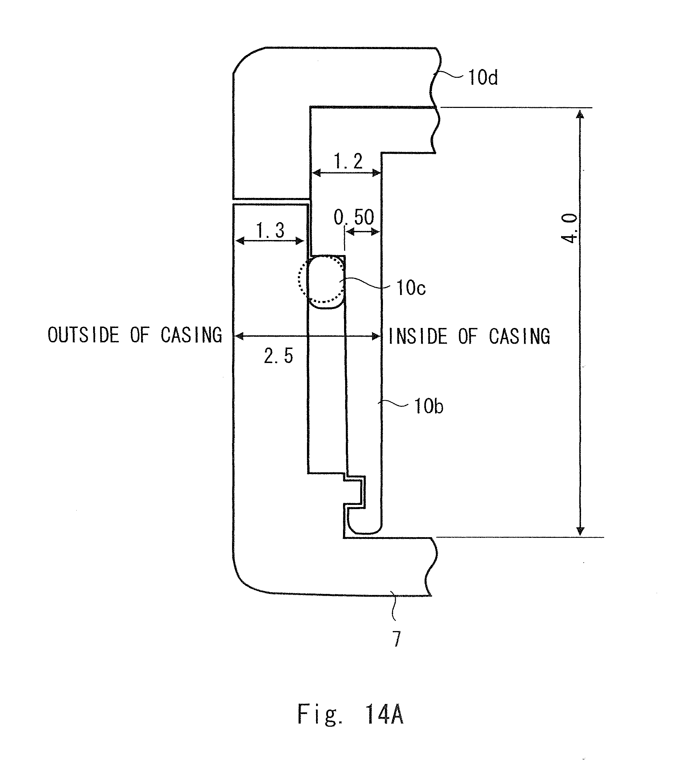

This waterproof structure is a type in which the seal member 10c made of rubber is integrally molded on the battery cover 10 forming the second casing 2 and is sandwiched between the battery cover 10 and the front cover 7 in the principal surface direction of the second casing 2. As a result, the seal member 10c is compressed to thereby secure the airtightness. Therefore, there has been a need to increase the thickness in the width direction (lateral direction in Fig. 14A) of each of the front cover 7 and the intermediate plate 10b so as to prevent the front cover 7 and the intermediate plate 10b from being deformed by the repulsive force of the seal member 10c.

Further, the intermediate plate 10b is provided with a fitting recess and the front cover 7 is provided with a fitting protrusion. These allow the front cover 7 and the battery cover 10 to be mechanically locked. In other words, a space for mechanical locking is also required.

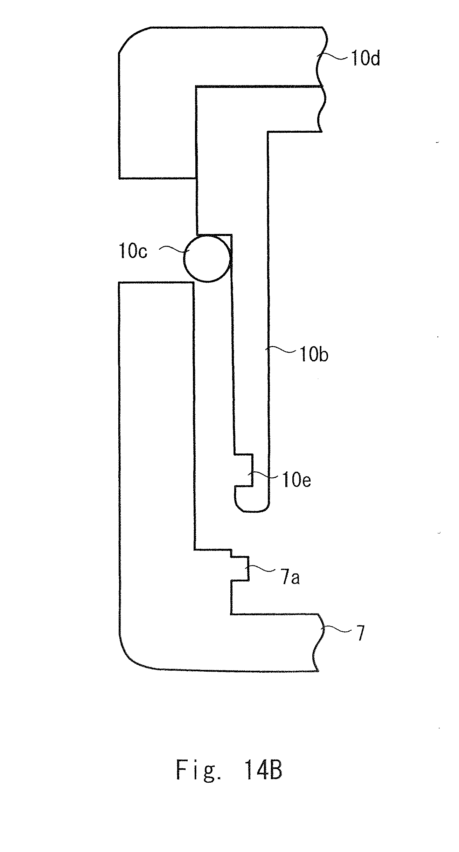

As described above, the waterproof structure shown in Figs. 14A and 14B requires a certain space, which causes a problem of difficulty in miniaturization and reduction in thickness of a portable device. As a technique for solving such a problem, Patent Literature 1 discloses a waterproof structure of a casing which is composed of a first case including a packing with a lip made of rubber formed along the internal perimeter of the case, and a second case including a U-groove into which the packing is inserted.

### Citation List

### Patent Literature

Japanese Unexamined Patent Application Publication No. 09-23072

### Summary of Invention

### Technical Problem

However, the waterproof structure disclosed in Patent Literature 1 has a problem that the contact area between the U-groove and the packing with a lip is small, and thus the waterproof structure is inferior in waterproofness.

It is an object of the present invention to provide a waterproof structure which is suitable for miniaturization and reduction in thickness of electronic devices and is excellent in waterproofness.

### Solution to Problem

A waterproof structure according to an exemplary aspect of the present invention includes:
a first casing component member;
a second casing component member that is fitted to the first casing component member and constitutes a casing;
an annular groove portion formed in the first casing component member; and
an annular seal member that is provided on the second casing component member and inserted into the groove portion, in which
a cross section of the seal member includes:
   a base portion;
   a trunk portion formed substantially perpendicular from the base portion; and
   a valve portion formed to protrude in a triangular shape from one side surface on a tip side of the trunk portion,
in a non-fitted state, a tip angle α of the valve portion is an acute angle and an angle θ formed between the valve portion and the trunk portion is equal to or smaller than 90°, and
in a fitted state, the trunk portion and the valve portion are housed in an enclosed space formed by the base portion and the groove portion.

A waterproofing method according to another exemplary aspect of the present invention includes the steps of:
forming an annular groove portion in a first casing component member;
providing an annular seal member on a second casing component member to be fitted to the first casing component member, the seal member being inserted into the groove portion; and
inserting the seal member into the groove portion to fit the first and second casing component members, in which
a cross section of the seal member includes:
   a base portion;
   a trunk portion formed substantially perpendicular from the base portion; and
   a valve portion formed to protrude in a triangular shape from one side surface on a tip side of the trunk portion,
in a non-fitted state, a tip angle α of the valve portion is an acute angle and an angle θ formed between the valve portion and the trunk portion is equal to or smaller than 90°, and
in a fitted state, the trunk portion and the valve portion are housed in an enclosed space formed by the base portion and the groove portion.

### Advantageous Effects of Invention

According to the present invention, it is possible to provide a waterproof structure which is suitable for miniaturization and reduction in thickness of portable devices and is excellent in waterproofness.

### Brief Description of Drawings

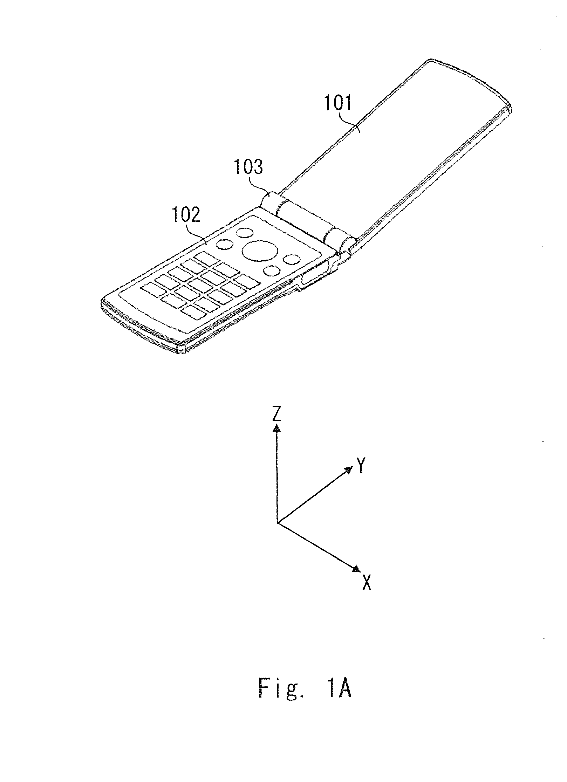

Fig. 1A is a perspective view showing the appearance of a folding portable telephone according to a first exemplary embodiment;

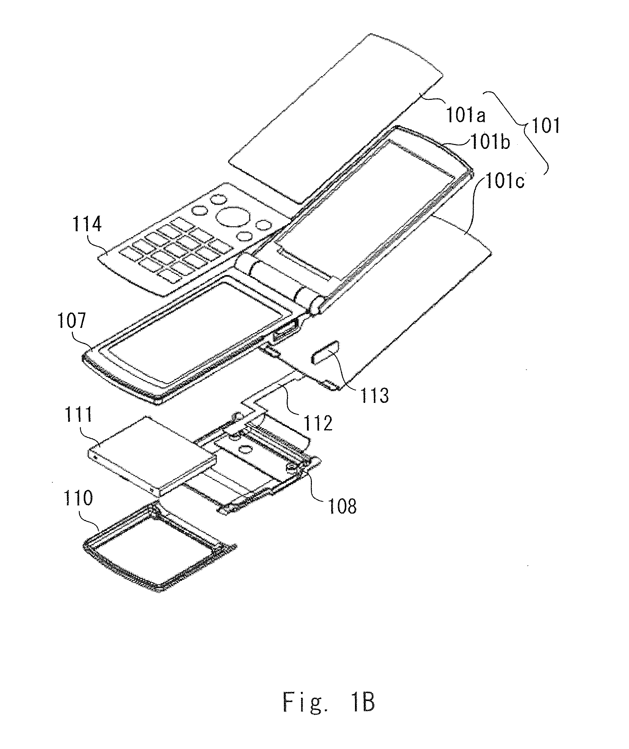

Fig. 1B is an exploded perspective view showing the configuration of the folding portable telephone according to the first exemplary embodiment;

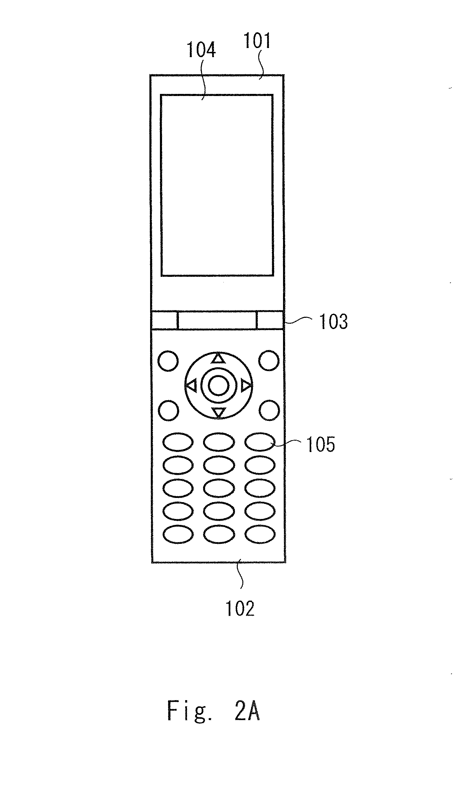

Fig. 2A is a front view of the folding portable telephone in an opened state according to the first exemplary embodiment;

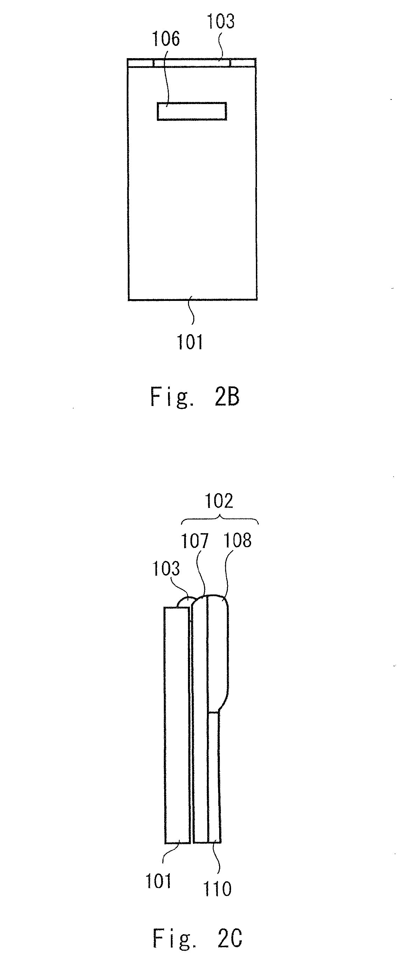

Fig. 2B is a front view of the folding portable telephone in a closed state according to the first exemplary embodiment;
Fig. 2C is a side view of the folding portable telephone in the closed state according to the first exemplary embodiment;

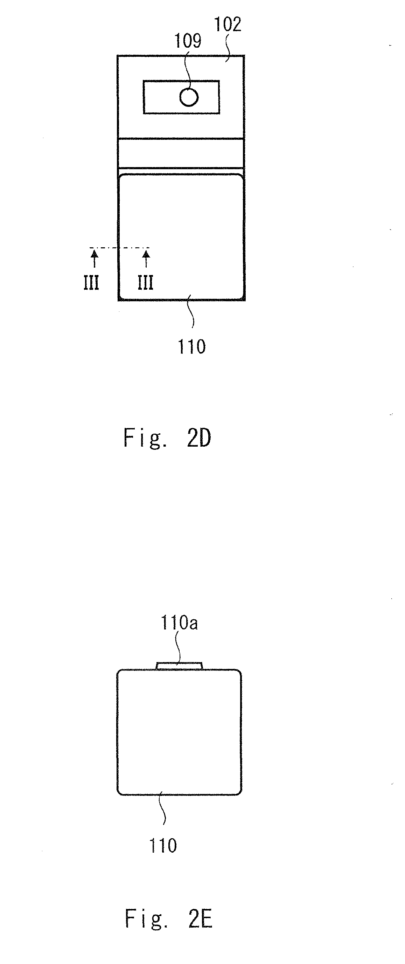

Fig. 2D is a back view of the folding portable telephone in the closed state according to the first exemplary embodiment;
Fig. 2E is a front view of a battery cover of the folding portable telephone according to the first exemplary embodiment;

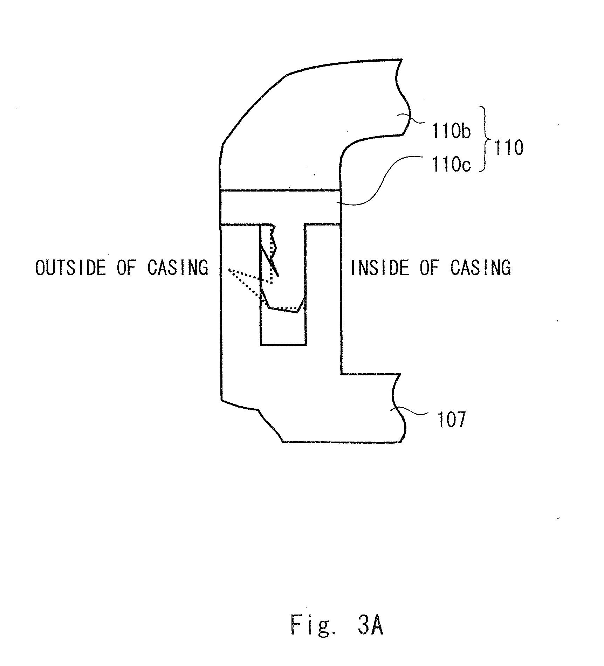

Fig. 3A is a sectional view (fitted state) taken along the line III-III of Fig. 2D;

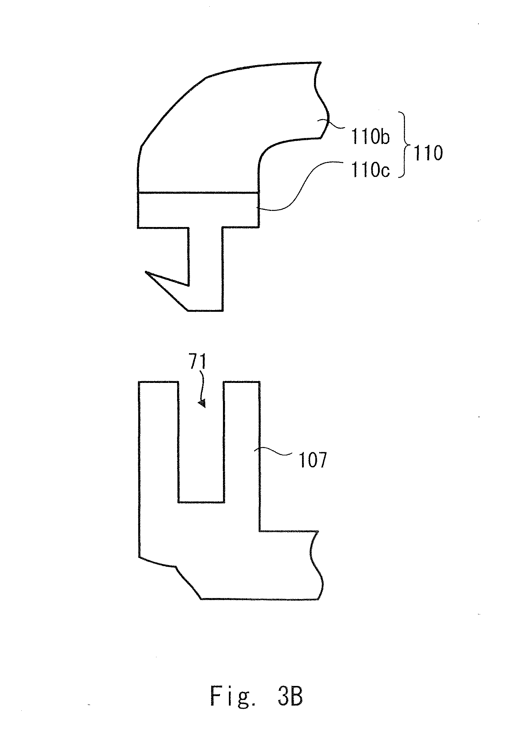

Fig. 3B is a sectional view (non-fitted state) taken along the line III-III of Fig. 2D;

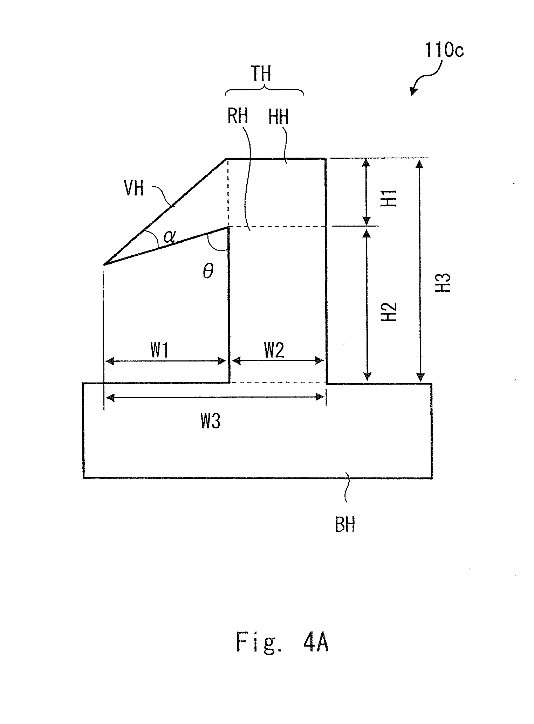

Fig. 4A is a sectional view of a seal member 110c according to the first exemplary embodiment;

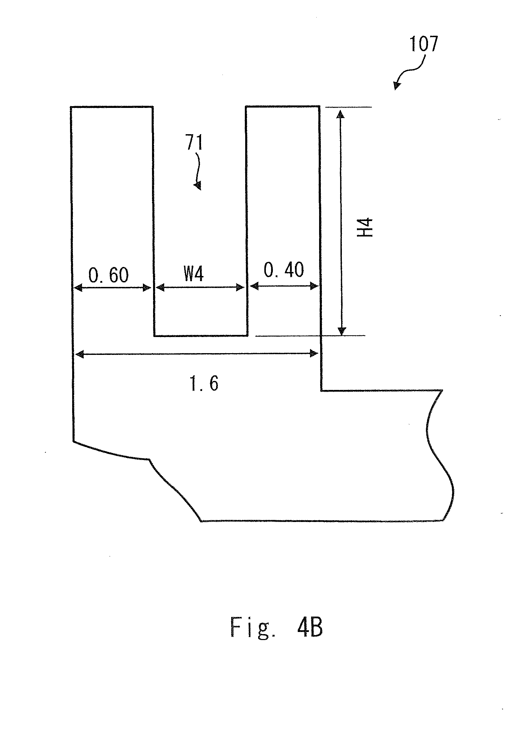

Fig. 4B is a sectional view of a groove portion 71 of a front cover 107 according to the first exemplary embodiment;

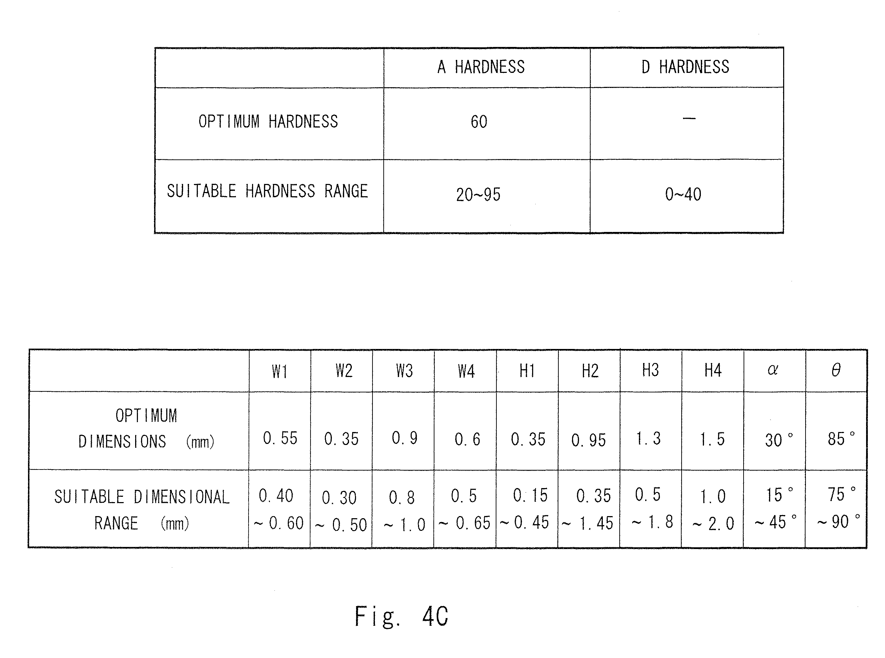

Fig. 4C is a table showing the optimum hardness, suitable hardness range, optimum dimensions, and suitable dimensional range of the seal member 110c according to the first exemplary embodiment;

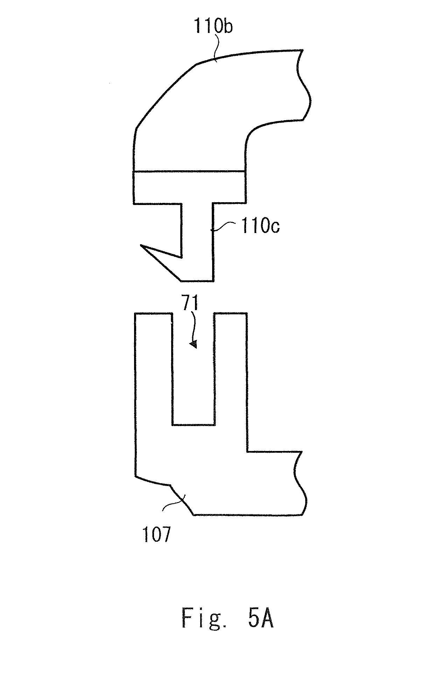

Fig. 5A is a sectional view showing a mechanism for fitting a battery cover 110 to the front cover 107 according to the first exemplary embodiment;

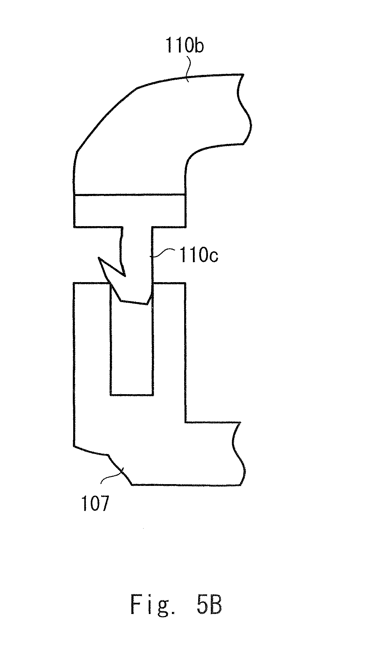

Fig. 5B is a sectional view showing a mechanism for fitting the battery cover 110 to the front cover 107 according to the first exemplary embodiment;

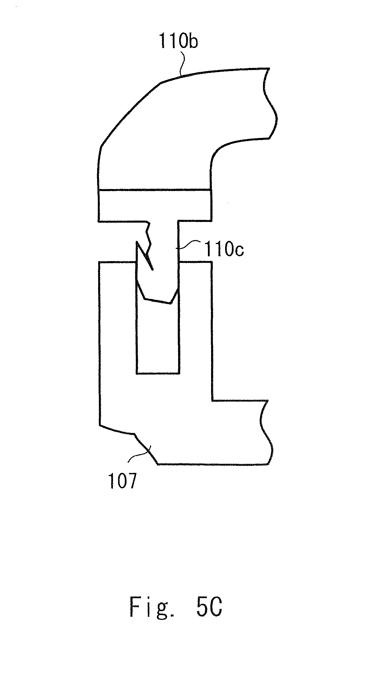

Fig. 5C is a sectional view showing a mechanism for fitting the battery cover 110 to the front cover 107 according to the first exemplary embodiment;

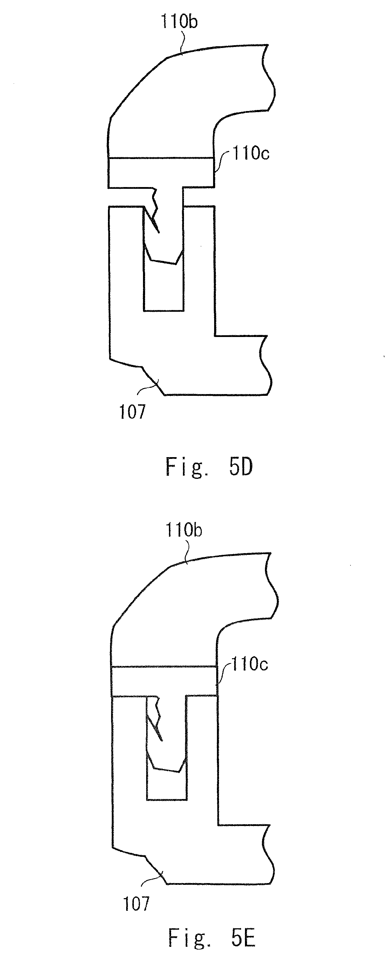

Fig. 5D is a sectional view showing a mechanism for fitting the battery cover 110 to the front cover 107 according to the first exemplary embodiment;
Fig. 5E is a sectional view showing a mechanism for fitting the battery cover 110 to the front cover 107 according to the first exemplary embodiment;

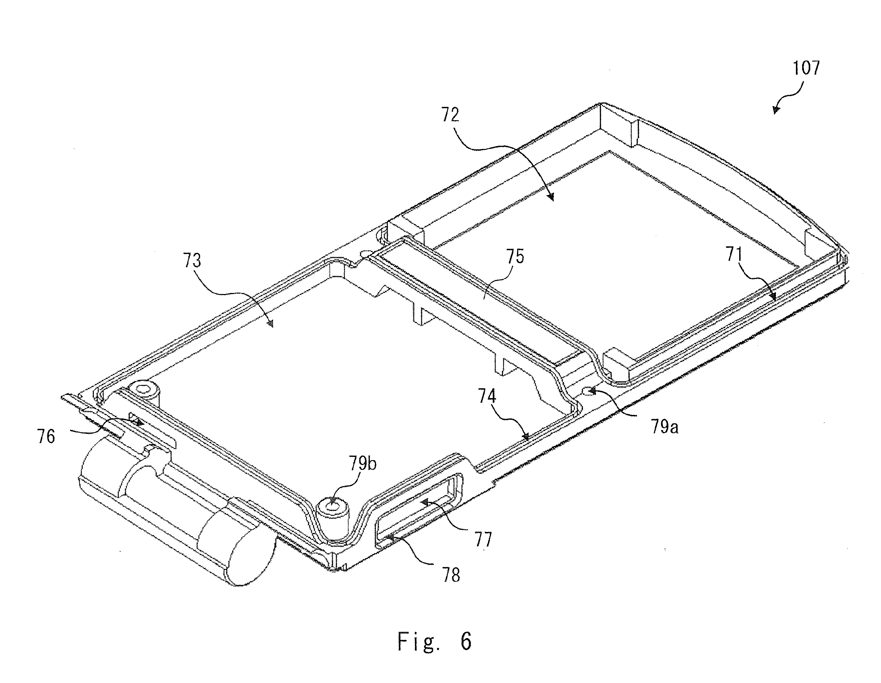

Fig. 6 is an overall perspective view of the front cover 107 of a second casing 2 according to the first exemplary embodiment;

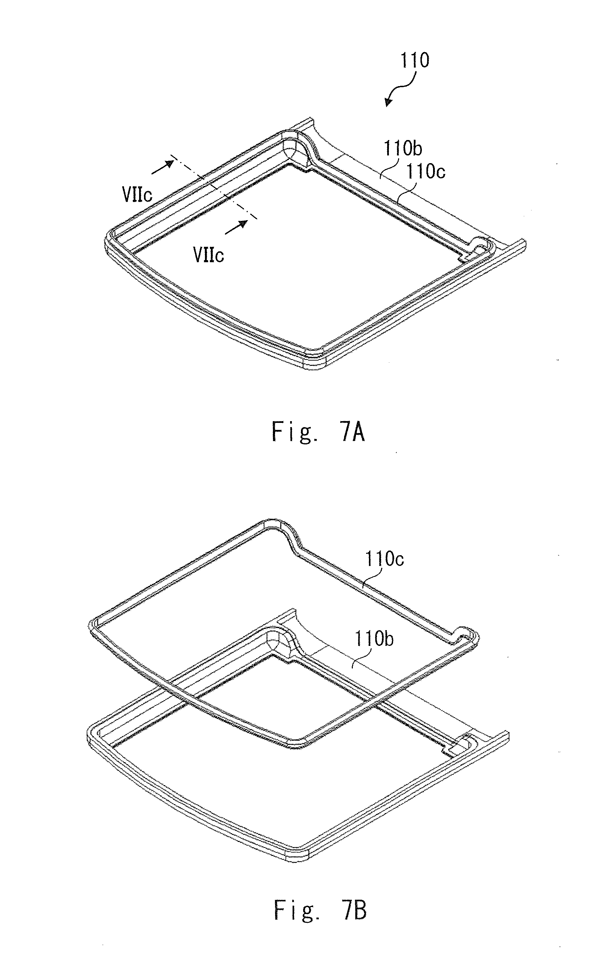

Fig. 7A is an overall perspective view of the battery cover 110 according to the first exemplary embodiment;
Fig. 7B is an exploded perspective view of the battery cover 110 according to the first exemplary embodiment;

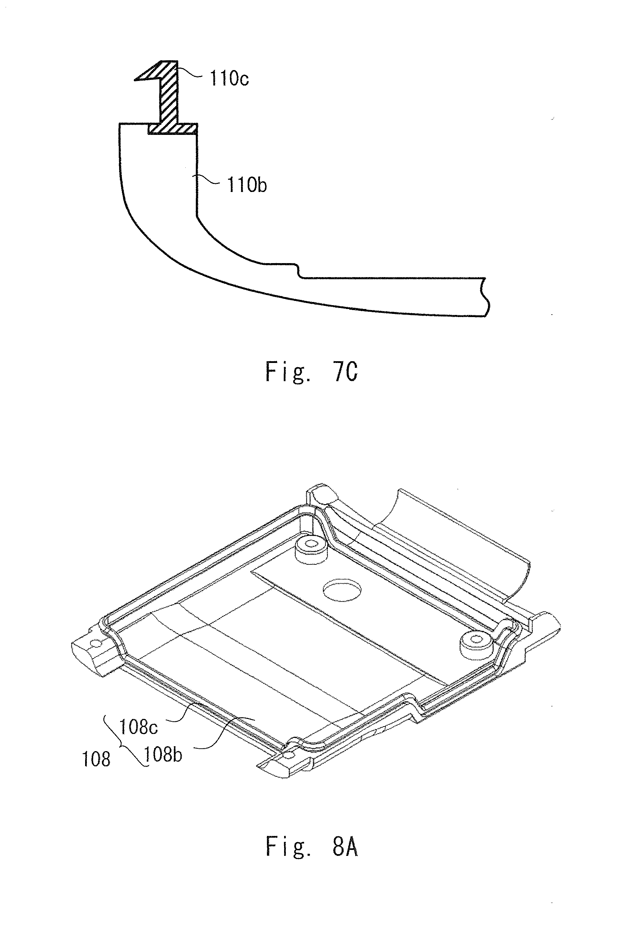

Fig. 7C is a sectional view taken along the line VIIc-VIIc of Fig. 7A;
Fig. 8A is an overall perspective view of a rear cover 108 of the second casing 2 according to the first exemplary embodiment;

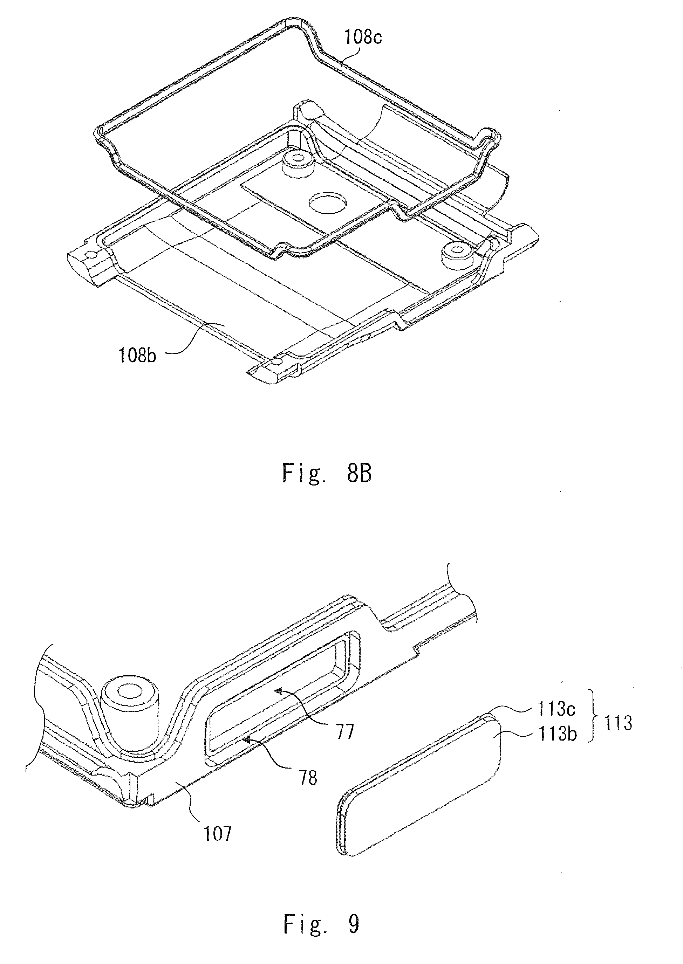

Fig. 8B is an exploded perspective view of the rear cover 108 of the second casing 2 according to the first exemplary embodiment;
Fig. 9 is a perspective view of an I/O cover 113 according to the first exemplary embodiment;

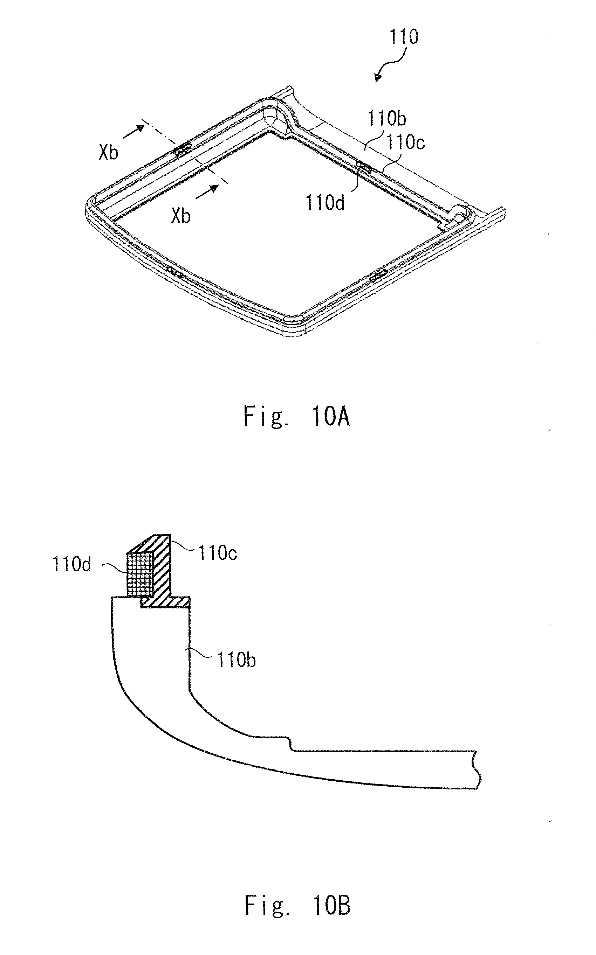

Fig. 10A is an overall perspective view of the battery cover 110 according to a second exemplary embodiment;
Fig. 10B is a sectional view taken along the line Xb-Xb of Fig. 10A;

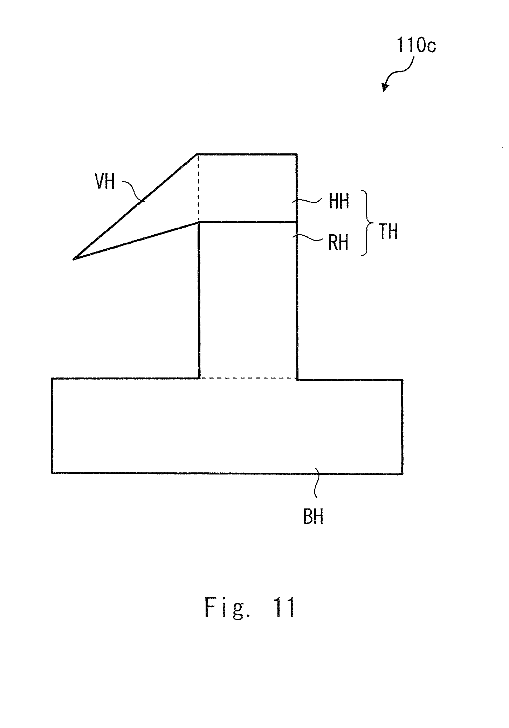

Fig. 11 is a sectional view of the seal member 110c according to a third exemplary embodiment;

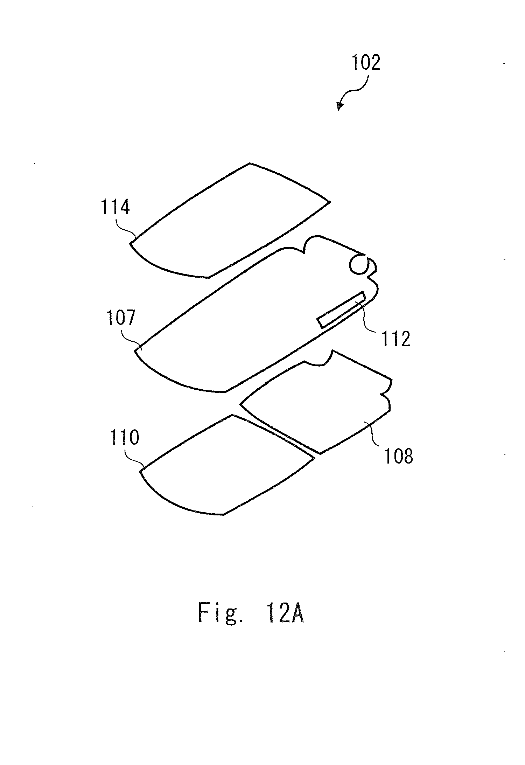

Fig. 12A is an exploded perspective view showing the configuration of a second casing 102 according to the first exemplary embodiment;

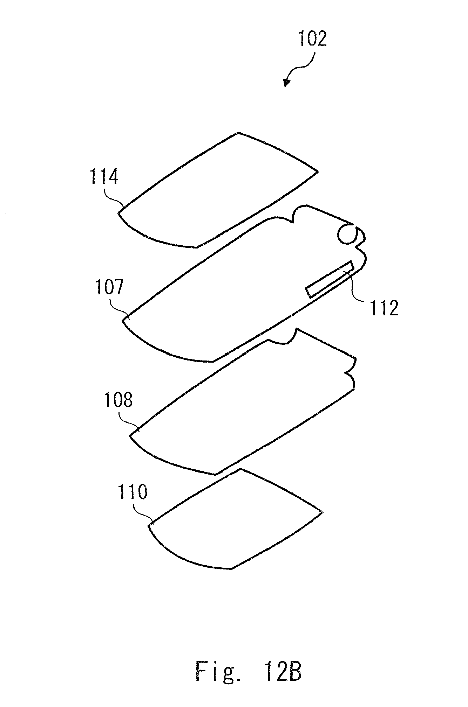

Fig. 12B is an exploded perspective view showing the configuration of the second casing 102 according to another exemplary embodiment;

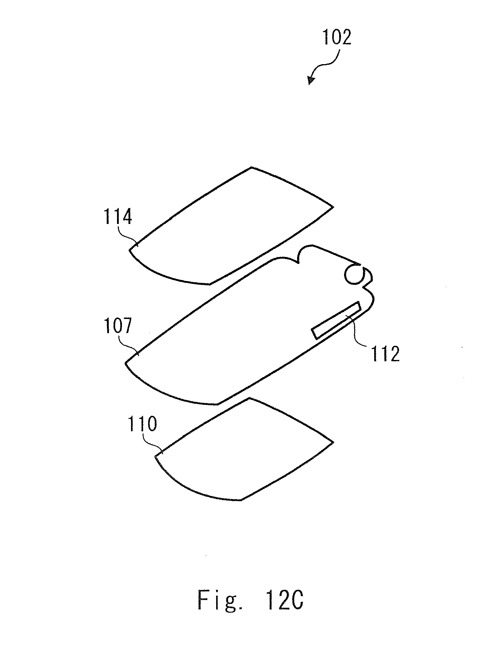

Fig. 12C is an exploded perspective view showing the configuration of the second casing 102 according to another exemplary embodiment;

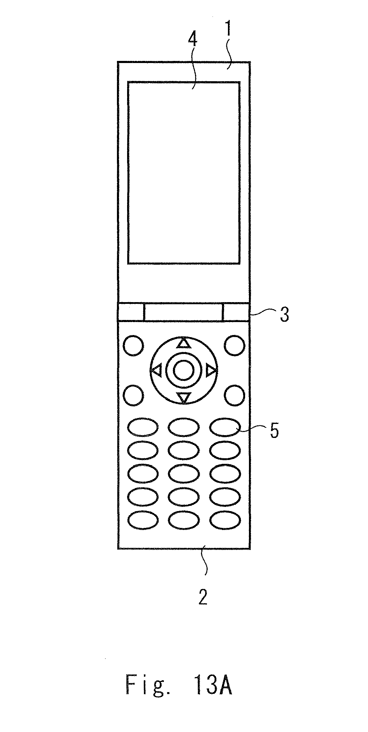

Fig. 13A is a front view of a folding portable telephone in the opened state according to a related art;

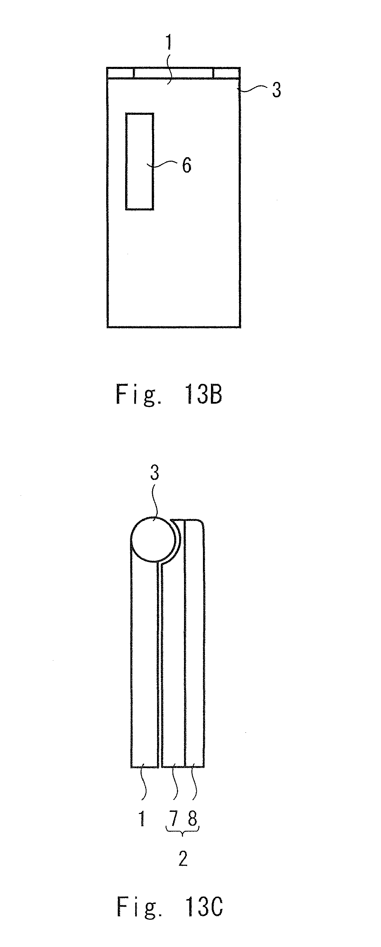

Fig. 13B is a front view of the folding portable telephone in the closed state according to the related art;
Fig. 13C is a side view of the folding portable telephone in the closed state according to the related art;

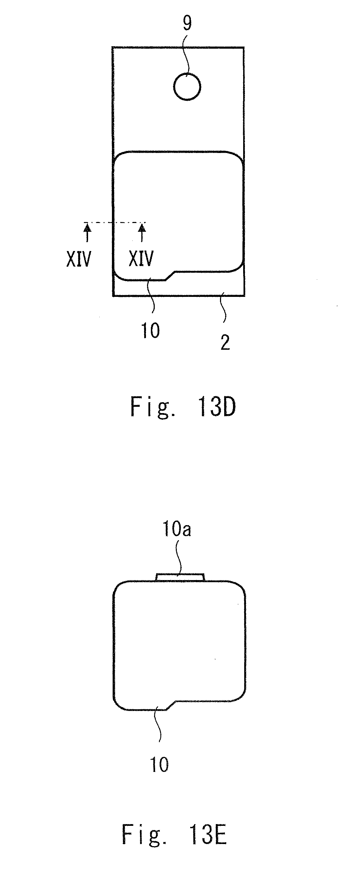

Fig. 13D is a back view of the folding portable telephone in the closed state according to the related art;
Fig. 13E is a front view of a battery cover of the folding portable telephone according to the related art;
Fig. 14A is a sectional view (fitted state) taken along the line XIV-XIV of Fig. 13D; and
Fig. 14B is a sectional view (non-fitted state) taken along the line XIV-XIV of Fig. 13D.

### Description of Embodiments

Hereinafter, specific exemplary embodiments of the present invention will be described in detail with reference to the drawings. However, the present invention is not limited to the exemplary embodiments described below. The following description and the drawings are appropriately simplified for clarity of explanation.

### (First exemplary embodiment)

An exemplary embodiment of the present invention will be described in detail with reference to the drawings. Fig. 1A is a perspective view showing the appearance of a folding portable telephone in an opened state according to a first exemplary embodiment. Fig. 1B is an exploded perspective view showing the configuration of the folding portable telephone in the opened state according to the first exemplary embodiment.

As shown in Fig. 1 A, the folding portable telephone according to the first exemplary embodiment includes a first casing 101, a second casing 102, and a hinge portion 103. As shown in Fig. 1, the principal surface of each casing is defined as an X-Y plane and a direction perpendicular to the principal surface of each casing is defined as a Z direction.

As shown in Fig. 1B, the first casing 101 includes a transparent front panel 101a that covers the front surface of a display device (not shown), a front cover 101b that houses the display device, and a rear cover 101c that covers the back surface of the display device. In this case, the front cover 101b and the rear cover 101c are joined together with a double-sided tape.

As shown in Fig. 1B, the second casing 102 includes a key sheet 114 that covers operation keys 105 (see Fig. 2A); a front cover 107 that houses a battery 111 and a main substrate (not shown); a battery cover 110 through which the battery 111 is taken in and out; and a rear cover 108 that covers the back surface of the main substrate. Further, the front cover 107 is provided with a detachably mounted I/O cover 113 for protecting an I/O connector.

In this case, the rear cover 108 is screwed to the front cover 107. Further, the key sheet 114 and the front cover 107 are joined together with a double-sided tape. Furthermore, each of the battery cover 110 and the I/O cover 113 is fitted to the front cover 107.

As shown in Fig. 1B, this portable telephone also includes a flexible substrate 112 that electrically connects the display device (not shown) which is housed in the first casing 101 and the main substrate (not shown) which is housed in the second casing 102. In this case, the flexible substrate 112 is disposed so as to pass through an opening (not shown) which is formed in the front cover 101b of the first casing 101 and an opening 76 (see Fig. 6) which is formed in the front cover 107 of the second casing 102. Then, the flexible substrate 112 is fitted into the two openings by an elastic member formed on the flexible substrate 112.

Referring next to Figs. 2A to 2E, a further description will be given. Fig. 2A is a front view of the folding portable telephone in the opened state according to the first exemplary embodiment. As shown in Fig. 2A, in this portable telephone, the first casing 101 and the second casing 102 are foldably connected by the hinge portion 103. The first casing 1 is provided with a main display portion 104. The second casing 2 is provided with various operation keys 105.

Fig. 2B is a front view of the folding portable telephone in a closed state according to the first exemplary embodiment. As shown in Fig. 2B, a sub-display portion 106 is provided on the surface opposite to the surface on which the main display portion 104 of the first casing 101 is provided.
Fig. 2C is a side view of the folding portable telephone in the closed state according to the first exemplary embodiment. As shown in Fig. 2C, the second casing 102 includes the front cover 107, the rear cover 108, and the battery cover 110.

Fig. 2D is a back view of the folding portable telephone in the closed state according to the first exemplary embodiment. As shown in Fig. 2D, a camera 109 and a detachably mounted battery cover 110 are provided on the surface opposite to the surface on which the operation keys 105 of the second casing 102 are provided.
Fig. 2E is a front view of the battery cover of the folding portable telephone according to the first exemplary embodiment. As shown in Fig. 2E, the battery cover 110 is provided with a guide claw 110a.

Referring next to Figs. 3A and 3B, a waterproof structure according to this exemplary embodiment will be described. Fig. 3A is a sectional view (fitted state) taken along the line III-III of Fig. 2D. Fig. 3B is a sectional view (non-fitted state) taken along the line III-III of Fig. 2D.

As shown in Figs. 3A and 3B, the battery cover 110 includes a seal member 110c formed of an elastic body, and an outer cover 110b of a resin mold. In this case, the seal member 110c has a hook-shaped cross section and is formed in a ring shape (annular shape) along the circumference of the outer cover 110b. The seal member 210c is integrally formed with the outer cover 110b. The elastic body is made of elastomer obtained by mixing resin and rubber. In the case of this elastomer, a primer for generating an adhesive force is not required, unlike the case of silicon rubber. Therefore, two-color molding of integral molding can be performed in the same mold immediately after the resin molding of the outer cover 110b.

On the other hand, the front cover 107 of the second casing 102 has a groove portion 71 into which the seal member 110c having a hook-shaped cross section is fitted in the fitted state shown in Fig. 3A.
Note that the overall shape of the seal member 110c and the groove portion 71 into which the seal member 110c is fitted will be described later with reference to Fig. 6 and Figs. 7A and 7B.

Fig. 4A is a sectional view of the seal member 110c according to the first exemplary embodiment. Fig. 4B is a sectional view of the groove portion 71 of the front cover 107 according to the first exemplary embodiment. As indicated by dashed lines in Fig. 4A, the seal member 110c is formed of a hook base (base portion) BH, a trunk portion TH, and a hook valve (valve portion) VH.

As shown in Fig. 4A, the trunk portion TH is formed substantially perpendicular to the hook base BH, and has a constant width (thickness) W2. To facilitate the explanation, assume herein that the trunk portion TH is divided into a book rib RH on the side of the hook base BH and a hook head HH on the tip side, for convenience. As shown in Fig. 4A, it can be said that the hook head HH connects the hook valve VH and the hook rib RH.
The hook valve VH is formed to protrude in a substantially triangular cross-sectional shape from one side surface on the tip side of the trunk portion TH. More specifically, the cross section of the hook valve VH is formed to protrude in a substantially triangular shape with one side surface of the hook head HH as a base.
That is, the hook valve VH is formed to be thin at its tip and thick at its root (a boundary surface between the hook value VH and the trunk portion TH). As shown in Figs. 3A and 3B, the hook valve VH is preferably formed to protrude toward the outside of the casing. However, the hook valve may be formed to protrude toward the inside of the casing.
An angle (hook angle) θ formed between the hook valve VH and the trunk portion TH is preferably equal to or smaller than 90°. Further, a tip angle (an angle formed between other two sides of the triangle with one side surface of the hook head HH as a base, and the angle is called a hook valve angle) α of the hook valve VH is preferably an acute angle. In this case, the tip of the hook valve VH may have a rounded shape. Also in such a case, the hook valve angle is preferably an angle formed between extensions of other two sides of the triangle with one side surface of the hook head HH as a base, and is also preferably an acute angle. The substantially triangular shape described above includes shapes having rounded tips.

As shown in Fig. 4A, the cross-sectional dimensions of the seal member 110c are defined by a height H1 of the hook head HH, a height H2 of the hook rib RH, (height H1)+(height H2)=(height H3), a width (a height from the boundary surface between the hook valve VH and the trunk portion TH to the tip of the hook valve VH) W1 of the hook valve VH, a width W2 of the trunk portion TH, (width W1)+(width W2)=(width W3), the hook valve angle α, and the hook angle θ. As shown in Fig. 4B, the cross-sectional dimensions of the front cover 107 are defined by a width W4 and a height H4 of the groove portion 71. Note that in this exemplary embodiment, as shown in Fig. 4B, the overall thickness in the casing principal surface direction (XY direction) of the front cover 107 is 1.6 mm. In the front cover 107, the thickness of the outside (outside of the casing) of the groove portion 71 is 0.60 mm, and the thickness of the inside (inside of the casing) of the groove portion 71 is 0.40 mm.

Fig. 4C shows optimum values and suitable ranges of the parameters H1 to H4, W1 to W4, α, and θ. Fig. 4C also shows the optimum values of the durometer A hardness of the elastomer forming the seal member 110c, and the suitable ranges of the durometer A hardness and the durometer D hardness. The optimum values are as follows: A hardness=60, W1=0.55 mm, W2=0.35 mm, W3=0.90 mm, W4=0.60 mm, H1=0.35 mm, H2=0.95 mm, H3=1.30 mm, H4=1.50 mm, α=30°, and θ=85°. The optimum values or suitable ranges shown in Fig. 4C allow the seal member 110c to be repeatedly elastically deformed without being plastically deformed.

Figs. 5A to 5E are sectional views each showing a mechanism for fitting the battery cover 110 to the front cover 107 according to the first exemplary embodiment. Fig. 5A shows a state (non-fitted state) in which the battery cover 110 and the front cover 107 are not fitted to each other.

Fig. 5B shows a state in which the seal member 110c of the battery cover 110 is inserted into the groove portion 71 of the front cover 107 and the outside surface of the hook valve VH and the outside surface of the groove portion 71 begin to contact each other. The contact between the outside surface of the hook valve VH and the outside surface of the groove portion 71 causes the hook valve VH to begin to warp and be deformed in a direction in which the hook angle θ decreases. At the same time, a rotation moment is generated in the hook head HH. As a result, the hook head HH begins to be rotationally deformed in a direction in which the side surface of the hook head HH separates from the inside surface of the groove portion 71. The term "inside surface" herein described refers to a side surface on the inside of the casing, and the term "outside surface" herein described refers to a side surface on the outside of the casing (the same hereinafter).

Figs. 5C and 5D show a state in which the seal member 110c is inserted into the groove portion 71. The inside surface of the hook rib RH and the inside surface of the groove portion 71 are always in close contact with each other. On the other hand, the close contact between the inside surface of the hook valve VH and the outside surface of the hook rib RH causes the rotation of the hook head to be stopped. In this case, the outside surface of the hook rib RH is compressed and deformed, which causes the outside surface of the hook rib RH to warp in a corrugated shape. That is, unlike the non-fitted state, a portion at which the width of the hook rib RH increases is generated. However, the gap provided between the outside surface of the hook rib RH and the outside surface of the groove portion 71 allows the seal member 110c to be smoothly fitted into the groove portion 71.

Fig. 5E shows a state in which the seal member 110c is completely inserted into the groove portion 71. In such a completely fitted state, the trunk portion TH and the hook valve VH are housed in an enclosed space formed by the hook base BH and the groove portion 71. Accordingly, the top surface of the hook base BH of the seal member 110c and the top surface of the front cover 107 forming the groove portion 71 are in close contact with each other. The inside surface of the groove portion 71 and the inside surface of the trunk portion TH are in close contact with each other in a large contact area. The outside surface of the groove portion 71 and the outside surface of the hook valve VH are in close contact with each other in a large contact area. Thus, the seal member 110c and the front cover 107 are in close contact with each other in many areas and the contact area is increased, thereby reliably securing the airtightness, that is, the waterproofness.

In the waterproof structure as shown in Figs. 3A and 3B according to an exemplary embodiment of the present invention, the size of the waterproof structure itself can be reduced, resulting in miniaturization and reduction in thickness of the portable device using the waterproof structure. The reasons for this are described below.

As shown in Figs. 3A and 3B, in the seal member 110c which is made of elastomer and has a hook-shaped cross section, the hook valve VH warps in the principal surface direction (XY direction) of the second casing 102, thereby securing the airtightness. Therefore, it is necessary to prevent the front cover 107 from being deformed by the deformation repulsive force of the seal member 110c. However, this deformation repulsive force is sufficiently smaller than the compression repulsive force of the seal member 10c which is made of silicon rubber and has a circular cross section shown in Figs. 14A and 14B. Accordingly, the thickness in the width direction (XY direction) of the front cover 107 can be reduced. Further, the trunk portion TH of the seal member 110c can be elastically deformed, which enables a reduction in the width W2 of the trunk portion TH.

Furthermore, since the hook angle θ is equal to or smaller than 90° and the hook valve angle α is an acute angle, the seal member 110c is easily inserted into the groove portion 71. Meanwhile, in the case of pulling the seal member 110c out of the groove portion 71, the hook valve VH is hooked at the outside surface of the groove portion 71 and the seal member 110c is hardly pulled out due to a large friction. That is, the interlocking force is large. Accordingly, there is no need to provide a mechanical lock as shown in Figs. 14A and 14B, and thus the size of the waterproof structure can be reduced.
In view of the above, the size of only the waterproof structure can be reduced without sacrificing the housing space for built-in components, that is, without sacrificing the functions of the built-in components. Consequently, the miniaturization and reduction in thickness of the portable device can be achieved.

Next, Fig. 6 is an overall perspective view of the front cover 107 according to the first exemplary embodiment. The front cover 107 includes the groove portion 71 into which the battery cover 110 is fitted; a battery housing space 72 for housing the battery 111; a main substrate housing space 73 for housing the main substrate (not shown); a groove portion 74 into which the rear cover 108 is fitted; a central rib 75 which partitions the battery housing space 72 and the main substrate housing space 73 and increases the strength of the front cover 107; the opening 76 through which the flexible substrate 112 penetrates; an opening 77 for the I/O connector; a groove portion 78 into which the I/O cover 113 is fitted; and two pairs of screw holes 79a and 79b.

Fig. 7A is an overall perspective view of the battery cover 110 according to the first exemplary embodiment. Fig. 7B is an exploded perspective view of the battery cover 110 according to the first exemplary embodiment. As shown in Fig. 7A, the battery cover 110 includes the seal member 110c made of elastomer, and the outer cover 110b of a resin mold. As shown in Fig. 7B, the seal member 110c is annularly and integrally formed along the circumference of the outer cover 110b. Fig. 7C is a sectional view taken along the line VIIc-VIIc of Fig. 7A. The seal member 110c having a hook-shaped cross section is integrally formed along the circumference of the outer cover 110b.

Fig. 8A is an overall perspective view of the rear cover 108 according to the first exemplary embodiment. Fig. 8B is an exploded perspective view of the rear cover 108 according to the first exemplary embodiment. As shown in Fig. 8A, the rear cover 108 includes a seal member 108c made of elastomer and an outer cover 108b of a resin mold. As shown in Fig. 8B, as with the seal member 11Oc, the seal member 108c is integrally formed in a ring shape along the circumference of the outer cover 108b. The seal member 108c of the rear cover 108 is fitted into the groove portion 74 of the front cover 107 shown in Fig. 6. The fitting mechanism is similar to that of the seal member 110c shown in Fig. 5.

The size of the waterproof structure itself can be reduced also when the waterproof structure shown in Figs. 3A and 3B is applied to the rear cover 108 shown in Figs. 8A and 8B. This leads to miniaturization and reduction in thickness of the portable device using the waterproof structure. The reliability of the waterproof function is also improved. The reasons for this are described below.

First, a waterproof structure according to a comparative example will be described. A typical waterproof structure in which the front cover 7 and the rear cover 8 are fitted together as shown in Fig. 13C is a type in which a seal member (not shown), such as an O-ring made of rubber or elastomer, is sandwiched between the front cover and the rear cover in the direction (Z direction) perpendicular to the principal surface of the casing. In this case, the front cover 7 and the rear cover 8 need to have a high rigidity so as to prevent the front cover 7 and the rear cover 8 from being deformed by the compression repulse force of the seal member. Accordingly, it is necessary to increase the thickness in the width direction (XY direction) and the height direction (Z direction) of each of the front cover 7 and the rear cover 8, as compared with a non-waterproof type. There is another type in which a mechanical lock such as a fitting claw is provided, like the battery cover 10 shown in Figs. 14A and 14B. That is, in the type in which the seal member is sandwiched in the direction (Z direction) perpendicular to the casing, the size of the waterproof structure itself is increased.

The seal member is compressed in the direction (Z direction) perpendicular to the principal surface of the casing, thereby securing the airtightness. Accordingly, it is necessary to increase the interlocking force so as to prevent formation of a gap in the height direction (Z direction) over the entire area of the front cover 7 and the rear cover 8 due to the compression repulsive force of the seal member. Therefore, in the non-waterproof type, four screws in total are required to be respectively screwed into four corners, while in the waterproof type. six screws in total including the four screws and two screws to be screwed into intermediate portions in the longitudinal direction are required. That is, the area provided with screws is increased.

In the type in which the seal member is sandwiched in the direction (Z direction) perpendicular to the casing, the seal member is constantly compressed at a compressibility of about 30%, for example. Accordingly, the amount of compression permanent strain of the seal member due to a secular change is large, and the sealing properties are liable to deteriorate. That is, the reliability of the sealing properties is low.

On the other hand, the waterproof structure according to this exemplary embodiment is not the type in which the seal member 108c is sandwiched in the direction (Z direction) perpendicular to the principal surface of the casing. Therefore, unlike the non-waterproof type, there is no need to increase the thickness in the width direction (XY direction) and the height direction (Z direction) of each of the front cover 107 and the rear cover 108.

Further, since the hook angle θ is equal to or smaller than 90° and the hook valve angle α is an acute angle, the seal member 108c can also be easily inserted into the groove portion 74. Meanwhile, in the case of pulling the seal member 108c out of the groove portion 74, the hook valve VH is hooked at the outside surface of the groove portion 74 and is hardly pulled out due to a large friction. That is, the interlocking force is large, which eliminates the need for a mechanical lock and enables reduction in the size of the waterproof structure. Furthermore, the number of screws can be reduced to be equal or smaller than that of the non-waterproof type.

In view of the above, the size of only the waterproof structure can be reduced without sacrificing the housing space for built-in components, that is, without sacrificing the functions of the built-in components. Consequently, the miniaturization and reduction in thickness of the portable device can be achieved.

Further, since the seal member 108c utilizes the deflective deformation of the hook valve VH, the amount of compression is small and deterioration caused by a compression permanent strain due to a secular change is small. Furthermore, the seal member 108c having an appropriate shape and hardness can be easily inserted into the groove portion 74 and is prevented from being plastically deformed due to buckling. The seal member 108c having an appropriate shape and hardness can also increase the adhesive properties among the hook valve VH, the trunk portion TH, and the groove portion 74. When a hydraulic pressure is generated due to submersion, the adhesive properties among the hook valve VH, the trunk portion TH, and the groove portion 74 are further increased. The seal member 108c can also absorb a deviation in the principal surface direction (XY direction) of the casing and a deviation in the direction (Z direction) perpendicular to the principal surface due to an external force. In view of the above, the reliability of the sealing properties is high.

Fig. 9 is a perspective view of the I/O cover 113 according to the first exemplary embodiment. As shown in Fig. 9, the I/O cover 113 includes a seal member 113c made of elastomer, and an outer cover 113b of a resin mold. As shown in Fig. 9, the seal member 113c is integrally formed in a ring shape along the circumference of the outer cover 113b, like the seal member 110c. The seal member 113c of the I/O cover 113 is fitted into the groove portion 78 of the front cover 107. The fitting mechanism is similar to that of the seal member 110c shown in Fig. 5.

### (Second exemplary embodiment)

Next, a second exemplary embodiment of the present invention will be described with reference to Figs. 10A and 10B.
Fig. 10A is an overall perspective view of the battery cover 110 according to the second exemplary embodiment. Fig. 10B is a sectional view taken along the line Xb-Xb of Fig. 10A. As shown in Fig. 10A, in the battery cover 110 according to the second exemplary embodiment, four stoppers 110d are provided so as to increase the interlocking force. Specifically, each of the stoppers 110d is provided in the vicinity of the center of each side of the seal member 110c having a substantially rectangular shape. As shown in Fig. 10B, each of the stoppers 110d is provided to contact the inside surface of the hook valve VH, the outside surface of the trunk portion TH, and the top surface on the outside of the hook base of the seal member 110c. The other components are similar to those of the first exemplary embodiment, so the description thereof is omitted.

### (Third exemplary embodiment)

Next, the second exemplary embodiment of the present invention will be described with reference to Fig. 11. Fig. 11 is a sectional view of the seal member 110c according to the third exemplary embodiment. In the seal member 110c according to the first exemplary embodiment, the hook base BH, the trunk portion TH, and the hook valve VH are integrally formed using the same material. On the other hand, as shown in Fig. 11, the hook base BH and the hook rib RH are formed of the same material, and the hook head HH and the hook valve VH are formed of the same material which is different from the material of the hook base BH and the hook rib RH. The other components are similar to those of the first exemplary embodiment, so the description thereof is omitted.

### (Other exemplary embodiment)

Next, other exemplary embodiments of the present invention will be described with reference to Figs. 12A to 12C. Fig. 12A is a schematic exploded perspective view showing the configuration of the second casing 2 according to the first exemplary embodiment. Fig. 12B is a schematic exploded perspective view showing the configuration of the second casing 2 according to another exemplary embodiment. In Fig. 12B, the rear cover 108 is formed over the whole casing 102. The battery cover 110 is disposed below the rear cover 108. Fig. 12C is a schematic exploded perspective view showing the configuration of the second casing 2 according to another exemplary embodiment. In Fig. 12C, the rear cover 108 is not provided. That is, the battery cover 110 is disposed below the front cover 107. The waterproof structure according to the above exemplary embodiments can also be applied to the configuration shown in Figs. 12B and 12C.

Note that the waterproof structure according to an exemplary embodiment of the present invention can be applied not only to the rear cover 108, the battery cover 1 10, and the I/O cover 113 of the second casing 102, but also to the front panel 101a, the front cover 101b, and the rear cover 101c of the first casing 101, the front cover 107 and the key sheet 114 of the second casing 102, and the elastic body formed on the flexible substrate 112.

In the above exemplary embodiments, rubber may be used instead of elastomer. The seal member 110c may include one or more stoppers to increase the interlocking force. Examples of the shape of each stopper may include a triangle, a square, a circle, an ellipse, and a polygon, and the shape of each stopper is not particularly limited. The hook rib RH may be formed of a hard material, such as resin or metal, and the hook valve VH and the hook head HH may be formed of an elastic material so that only the hook valve VH and the hook head HH are allowed to warp.

Though the present invention has been described above with reference to exemplary embodiments, the present invention is not limited to the above exemplary embodiments. The configuration and details of the present invention can be modified in various manners which can be understood by those skilled in the art within the scope of the invention.

This application is based upon and claims the benefit of priority from Japanese patent application No. 2010-058034, filed on March 15, 2010, the disclosure of which is incorporated herein in its entirety by reference.

### Industrial Applicability

A waterproof structure according to this exemplary embodiment is not limited to a portable telephone, but is also applicable to portable electronic devices such as a portable game device, a portable computer, and a portable music player, a desktop computer, various remote controllers, and other electronic devices.

### (Supplementary note 1)

A waterproof structure comprising:
a first casing component member;
a second casing component member that is fitted to the first casing component member and constitutes a casing;
an annular groove portion formed in the first casing component member; and
an annular seal member that is provided on the second casing component member and inserted into the groove portion, wherein
a cross section of the seal member includes:
   a base portion;
   a trunk portion formed substantially perpendicular from the base portion; and
   a valve portion formed to protrude in a triangular shape from one side surface on a tip side of the trunk portion,
in a non-fitted state, a tip angle α of the valve portion is an acute angle and an angle θ formed between the valve portion and the trunk portion is equal to or smaller than 90°, and
in a fitted state, the trunk portion and the valve portion are housed in an enclosed space formed by the base portion and the groove portion.

### (Supplementary note 2)

The waterproof structure according to Supplementary note 1, wherein in the fitted state,
a side surface of the groove portion on an inside of the casing and a side surface of the trunk portion on the inside of the casing are in close contact with each other, and
a side surface of the groove portion on an outside of the casing and a side surface of the valve portion on the outside of the casing are in close contact with each other.

### (Supplementary note 3)

The waterproof structure according to Supplementary note 1 or 2, wherein in the non-fitted state, the tip angle α of the valve portion is an acute angle and the angle θ formed between the valve portion and the trunk portion is equal to or smaller than 90°.

### (Supplementary note 4)

The waterproof structure according to any one of Supplementary notes 1 to 3, wherein the valve portion is formed to protrude to an outside of the casing.

### (Supplementary note 5)

The waterproof structure according to any one of Supplementary notes 1 to 3, wherein at least the valve portion and a tip portion of the trunk portion are integrally formed of the same type of elastic body.

### (Supplementary note 6)

The waterproof structure according to Supplementary note 5, wherein the whole seal member is integrally formed of the same type of elastic body.

### (Supplementary note 7)

The waterproof structure according to Supplementary note 5 or 6, wherein the elastic body is elastomer.

### (Supplementary note 8)

The waterproof structure according to any one of Supplementary notes 5 to 7, wherein the elastic body has a durometer A hardness of 20 to 95.

### (Supplementary note 9)

The waterproof structure according to any one of Supplementary notes 1 to 8, wherein the angle α is 30° to 45°.

### (Supplementary note 10)

The waterproof structure according to any one of Supplementary notes 1 to 9, wherein the angle θ is 75° to 90°.

### (Supplementary note 11)

The waterproof structure according to any one of Supplementary notes 1 to 10, wherein the seal member is integrally formed with the second casing component member by two-color molding.

### (Supplementary note 12)

The waterproof structure according to any one of Supplementary notes 1 to 11, wherein the seal member further includes at least one stopper provided in contact with the base portion, the trunk portion, and the valve portion.

### (Supplementary note 13)

An electronic device comprising a waterproof structure according to any one of Supplementary notes 1 to 12.

### (Supplementary note 14)

The electronic device according to Supplementary note 13, wherein the electronic device is a portable electronic device.

### (Supplementary note 15)

The electronic device according to Supplementary note 14, wherein the electronic device is a portable telephone.

### (Supplementary note 16)

A waterproofing method comprising the steps of:
forming an annular groove portion in a first casing component member;
providing an annular seal member on a second casing component member to be fitted to the first casing component member, the seal member being inserted into the groove portion; and
inserting the seal member into the groove portion to fit the first and second casing component members, wherein
a cross section of the seal member includes:
   a base portion;
   a trunk portion formed substantially perpendicular from the base portion; and
   a valve portion formed to protrude in a triangular shape from one side surface on a tip side of the trunk portion, and
in a fitted state, the trunk portion and the valve portion are housed in an enclosed space formed by the base portion and the groove portion.

### Reference Signs List

- 1: FIRST CASING
- 2: SECOND CASING
- 3: HINGE PORTION
- 4: MAIN DISPLAY PORTION
- 5: OPERATION KEY
- 6: SUB-DISPLAY PORTION
- 7: FRONT COVER
- 8: REAR COVER
- 9: CAMERA
- 10: BATTERY COVER
- 10a: GUIDE CLAW
- 10b: INTERMEDIATE PATE
- 10c: SEAL MEMBER
- 10d: OUTER COVER
- 71: GROOVE PORTION
- 72: BATTERY HOUSING SPACE
- 73: MAIN SUBSTRATE HOUSING SPACE
- 74: GROOVE PORTION
- 75: CENTRAL RIB
- 76: OPENING
- 77: OPENING
- 78: GROOVE PORTION
- 79a, 79b: SCREW HOLE
- 101: FIRST CASING
- 101a: FRONT PANEL
- 101b: FRONT COVER
- 101c: REAR COVER
- 102: SECOND CASING
- 103: HINGE PORTION
- 104: MAIN DISPLAY PORTION
- 105: OPERATION KEY
- 106: SUB-DISPLAY PORTION
- 107: FRONT COVER
- 108: REAR COVER
- 108b: OUTER COVER
- 108c: SEAL MEMBER
- 109: CAMERA
- 110: BATTERY COVER
- 110a: GUIDE CLAW
- 110b: OUTER COVER
- 110c: SEAL MEMBER
- 110d: STOPPER
- 111: BATTERY
- 112: FLEXIBLE SUBSTRATE
- 113: I/O COVER
- 113b: OUTER COVER
- 113c: SEAL MEMBER
- 114: KEY SHEET
- BH: HOOK BASE
- HH: HOOK HEAD
- RH: HOOK RIB
- VH: HOOK VALVE

## Claims

1. A waterproof structure comprising:
a first casing component member;
a second casing component member that is fitted to the first casing component member and constitutes a casing;
an annular groove portion formed in the first casing component member; and
an annular seal member that is provided on the second casing component member and inserted into the groove portion, wherein
a cross section of the seal member includes:
a base portion;
a trunk portion formed substantially perpendicular from the base portion; and
a valve portion formed to protrude in a triangular shape from one side surface on a tip side of the trunk portion, and
in a fitted state, the trunk portion and the valve portion are housed in an enclosed space formed by the base portion and the groove portion.

2. The waterproof structure according to Claim 1, wherein in the fitted state,
a side surface of the groove portion on an inside of the casing and a side surface of the trunk portion on the inside of the casing are in close contact with each other, and
a side surface of the groove portion on an outside of the casing and a side surface of the valve portion on the outside of the casing are in close contact with each other.

3. The waterproof structure according to Claim 1 or 2, wherein in a non-fitted state, a tip angle α of the valve portion is an acute angle, and an angle θ formed between the valve portion and the trunk portion is equal to or smaller than 90°.

4. The waterproof structure according to any one of Claims 1 to 3, wherein the valve portion is formed to protrude to an outside of the casing.

5. The waterproof structure according to any one of Claims 1 to 4, wherein at least the valve portion and a tip portion of the trunk portion are integrally formed of the same type of elastic body.

6. The waterproof structure according to Claim 5, wherein the whole seal member is integrally formed of the same type of elastic body.

7. The waterproof structure according to Claim 5 or 6, wherein the elastic body is elastomer.

8. The waterproof structure according to any one of Claims 5 to 7, wherein the elastic body has a durometer A hardness of 20 to 95.

9. An electronic device comprising a waterproof structure according to any one of Claims 1 to 8.

10. A waterproofing method comprising the steps of:
forming an annular groove portion in a first casing component member;
providing an annular seal member on a second casing component member to be fitted to the first casing component member, the seal member being inserted into the groove portion; and
inserting the seal member into the groove portion to fit the first and second casing component members, wherein
a cross section of the seal member includes:
a base portion;
a trunk portion formed substantially perpendicular from the base portion; and
a valve portion formed to protrude in a triangular shape from one side surface on a tip side of the trunk portion, and
in a fitted state, the trunk portion and the valve portion are housed in an enclosed space formed by the base portion and the groove portion.
